# EUROPEAN PATENT APPLICATION

(11) **EP 1 876 712 A1**
(43) Date of publication of application: **09.01.2008**
(21) Application number: 06715387.4
(22) Date of filing: 08.03.2006
(51) Int. Cl.: H03L 7/08

(54) **CLOCK GENERATING CIRCUIT AND AUDIO SYSTEM**

(30) Priority: 25.04.2005 JP 2005125875
(71) Applicant: Niigata Seimitsu Co., Ltd., Jouetsu-shi, Niigata 943-0834 (JP); Ricoh Company, Ltd., Tokyo 143-8555 (JP)
(72) Inventor: MIYAGI, Hiroshi c/o Niigata Seimitsu Co., Ltd., Niigata 943 0834 (JP)
(74) Representative: Murgatroyd, Susan Elizabeth
(86) International application number: PCT/JP2006/304467
(87) International publication number: WO 2006/114941

(57) **Abstract**

A clock generating circuit having a simple constitution and an audio system are disclosed.

The clock generating circuit (300) comprises an oscillator (12) for generating a reference frequency signal by means of a crystal oscillator (10) of a resonance frequency of 32.768 kHz, a PLL circuit for generating a signal synchronizing with the reference frequency signal generated by the oscillator (12) and having a frequency which is M times the reference frequency signal, a first frequency divider (30) for generating a first clock signal (CLK1) having a frequency of 32 kHz by frequency-dividing the signal generated by the PLL circuit at a division ratio N1, a second frequency divider (32) for generating a second clock signal (CLK2) having a frequency of 38 kHz by frequency-dividing the signal generated by the PLL circuit at a division ratio N2, and a third frequency divider (34) for generating a third clock signal (CLK3) having a frequency of 48 kHz by frequency-dividing the signal generated by the PLL circuit at a division ratio N3.

## Description

### Technical Field

The present invention relates to a clock generating circuit for generating clock signals having a plurality of frequencies, and an audio system.

### Background Art

In recent years, various kinds of audio devices achieved by means of digital processing have been put to practical use. However, since sampling frequencies used for each specification have been already determined in many cases, different frequencies of clock signals are required for each audio device. Moreover, in order to transmit audio signals from the audio devices and output them from the speaker of an external FM receiver, an audio device having a function of a transmitter is also put to practical use (for example, refer to Patent Document 1).

Patent Document 1: Japanese Patent Laid-Open No. 2002-260324 (pp 3 to 6, Figures 1 to 6)

### Disclosure of the Invention

Incidentally, when the audio signals corresponds to the various kinds of sampling frequencies such as ones disclosed in Patent Document 1 mentioned above are transmitted by using a FM transmitter, each clock signal corresponds to the plurality of sampling frequencies and clock signal of frequency required for modulation by the FM transmitter are required. For example, clock signals of 32 kHz and 48 kHz are required for DVD and MP3 (MPEG Audio Layer-3), respectively, and a clock signal of 38 kHz is required for the sub-carriers of FM stereo modulation. Since it has been required that individual clock generating circuits are included for the plurality of clock signals, there has been a problem that the structures of audio devices are caused to be complicated.

The present invention is devised in view of such a point, and the object of the present invention is to provide a clock generating circuit and an audio system enabling the structures thereof to be simplified.

In order to solve the above mentioned problem, the clock generating circuit of the present invention includes an oscillator for generating a reference frequency signal by means of a crystal oscillator of a resonance frequency of 32.768 kHz, a PLL circuit for generating a signal synchronizing with the reference frequency signal generated by the oscillator and having a frequency which is M times the reference frequency signal, a first frequency divider for generating a first clock signal having a frequency which is an integer multiple of 32 kHz by frequency-dividing the signal generated by the PLL circuit at a division ratio N1, a second frequency divider for generating a second clock signal having a frequency which is an integer multiple of 38 kHz by frequency-dividing the signal generated by the PLL circuit at a division ratio N2, and a third frequency divider for generating a third clock signal having a frequency which is an integer multiple of 48 kHz by frequency-dividing the signal generated by the PLL circuit at a division ratio N3. This enables two kinds of clock signals required for processing audio data with sampling frequencies of 32 kHz and 48 kHz, widely used for digital audio, and a clock signal of 38 kHz, required for stereo modulation, to be generated by a common clock generating circuit using one phase-locked loop (PLL) circuit, resulting in simplification of the structure thereof. Moreover, since a crystal oscillator of 32.768 kHz is used for generating the reference frequency of a clock, and is commercially available in a low cost, use the crystal oscillator enables the cost thereof to be reduced.

Moreover, it is desirable that when the above-mentioned reference frequency signal has a frequency which is (1/N4) times of 32.768 kHz, the division ratio N1 of a first frequency divider is set to a value determined by (32.768 × M)/(32 × N4) or a value which is the division of the former value by the number of the power of two. Setting specifically such a division ratio, enables a clock signal having a frequency of 32 kHz or 32 kHz multiplied by the power of two to be generated.

Moreover, it is desirable that when the above-mentioned reference frequency signal has a frequency which is (1/N4) times of 32.768 kHz, the division ratio N2 of a second frequency divider is set to a value determined by (32.768 × M)/(38 × N4) or a value which is the division of the former value by the number of the power of two. Setting specifically such a division ratio, enables a clock signal having a frequency of 38 kHz or 38 kHz multiplied by the power of two to be generated.

Moreover, it is desirable that when the above-mentioned reference frequency signal has a frequency which is (1/N4) times of 32.768 kHz, the division ratio N3 of a third frequency divider is set to a value determined by (32.768 × M)/(48 × N4) or a value which is the division of the former value by the number of the power of two. Setting specifically such a division ratio, enables a clock signal having a frequency of 48 kHz or 48 kHz multiplied by the power of two to be generated.

Moreover, it is desirable that the above-mentioned N1, N2, N3, N4, and M are integers. This enables the construction of the frequency divider to be simplified.

Moreover, the audio system of the present invention includes: the above-mentioned clock generating circuit; an audio processing section for performing audio data reproduction by using at least one of the first and third clock signals generated by the clock generating circuit; and an FM transmitter into which the audio data reproduced by the audio processing section is input, for transmitting a signal subjected to FM stereo modulation and FM modulation with respect to the input audio data by using a second clock signal generated by the clock generating circuit. Since this enables two kinds of clock signals of 32 kHz and 48 kHz input to the audio processing section, and a clock signal of 38 kHz input to the FM transmitter to be generated by a common clock generating circuit, the construction of device of the entire audio system can be simplified.

### Brief Description of the Drawings

Figure 1 is a view illustrating the configuration of the audio system of one embodiment; and
Figure 2 is a view illustrating the detailed configuration of the clock generating circuit.

### Description of Symbols

- 10: CRYSTAL OSCILLATOR
- 12: OSCILLATOR (OSC)
- 14, 26, 30, 32, 34: FREQUENCY DIVIDERS
- 20: PHASE COMPARATOR (PD)
- 22: LOW PASS FILTER (LPF)
- 24: VOLTAGE CONTROLLED OSCILLATOR (VCO)
- 100: AUDIO PROCESSING SECTION
- 200: FM TRANSMITTER
- 210: STEREO MODULATION SECTION
- 300: CLOCK GENERATING CIRCUIT

### Best Mode for Carrying Out the Invention

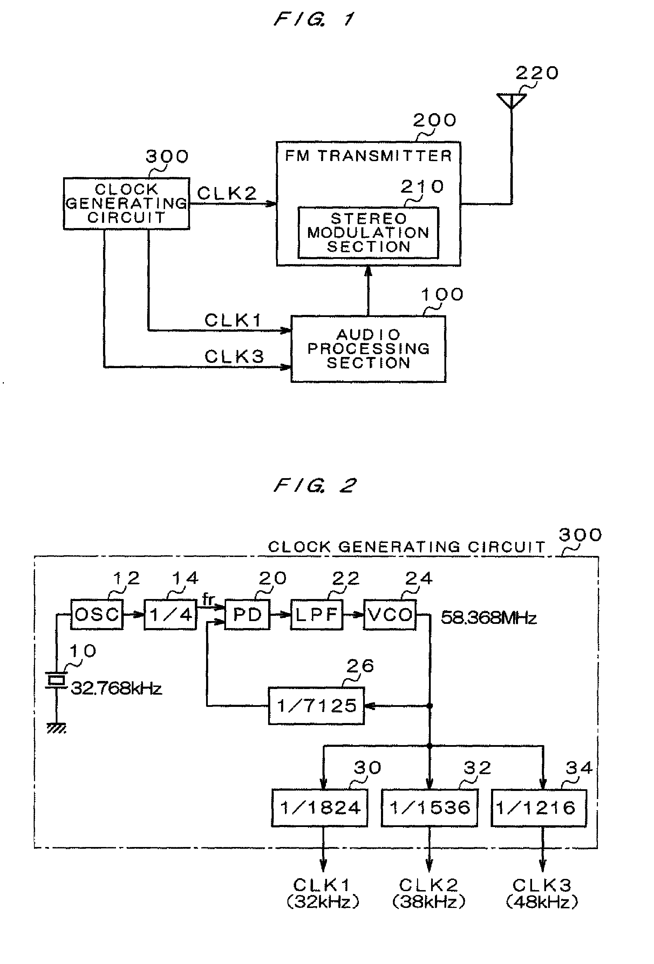

Hereinafter, the audio system of one embodiment applying the present invention will be described with reference to drawings. Figure 1 is a view illustrating the configuration of the audio system of the present embodiment. As illustrated in Figure 1, the audio system of the present embodiment is configured by including: an audio processing section 100; an FM transmitter 200; and a clock generating circuit 300. Most of the configurations of the audio processing section 100, the FM transmitter 200 and the clock generating circuit 300 are formed on a semiconductor substrate by means of a CMOS process or an MOS process, as one chip component (except for the crystal oscillator 10 (will be described later) and drive mechanism etc. which cannot be formed by means of the processes). Use of the processes enables miniaturization and low power consumption of one chip component formed on the semiconductor substrate and whole of the audio system to be achieved.

The audio processing section 100 performs reproduction of the digital audios corresponding to each of a plurality of sampling frequencies. For example, the audio processing section 100 performs reproduction of the audio data having a sampling frequency of 32 kHz input from a DVD drive (not illustrated in figures), and reproduction of an audio data having a sampling frequency of 32 kHz or 48 kHz recorded in MP3 form, selectively. Clock signals of 32 kHz and 48 kHz required by the reproductions are input from the clock signal generating circuit 300.

The FM transmitter 200 subjects the audio data generated by reproduction through the audio processing section 100 to FM stereo modulation and FM modulation, and transmits the FM modulated signal from an antenna 220. The signal is received by an external FM receiver, and the audio sound of the audio data output from the audio processing section 100 is output from the speaker of the FM receiver. The FM transmitter 200 is provided with a stereo modulation section 210 for performing FM stereo modulation. In the stereo modulation section 210, stereo compound data (composite data) is generated by subjecting L/R audio data input from the audio data processing section 100 to stereo modulation synchronized with a subcarrier of 38 kHz, and a clock signal of 38 kHz required for the processing is input from the clock generating circuit 300.

The clock generating circuit 300 generates a first clock signal CLK1 having a frequency of 32 kHz, a second clock signal CLK2 having a frequency of 38 kHz, and a third clock signal CLK3 having a frequency of 48 kHz, by using a 32.768 kHz crystal oscillator.

Figure 2 is a view of the detailed configuration of the clock generating circuit 300. As illustrated in Figure 2, the clock generating circuit 300 includes a crystal oscillator 10, an oscillator (OSC) 12, frequency dividers 14, 26, 30, 32, and 34, a phase comparator (PD) 20, a low pass filter (LPF) 22, and a voltage controlled oscillator (VCO) 24.

The resonance frequency of the crystal oscillator 10 is 32.768 kHz. The crystal oscillator 10 is of kind widely used on the market for clocks, and can be available in a low cost. The oscillator 12 performs oscillation of 32.768 kHz by using the crystal oscillator 10 for a part of the resonant circuit thereof, and outputs an oscillation signal. The frequency of the oscillation signal is divided by 4 through the frequency divider 14 whose division ratio is 4 (N = 4), and input into one input terminal of the phase comparator 20 as a reference frequency signal fr of 8.192 kHz.

The phase comparator 20 compares the phase of the reference frequency signal fr and the phase of the output signal of the frequency divider 26 input into the other input terminal thereof, and outputs a signal according to the phase difference between them. The low pass filter 22 smoothes the output signal of the phase comparator 20, and generates a control voltage to be applied to the voltage controlled oscillator 24. The voltage controlled oscillator 24 performs oscillation at a frequency according to the control voltage applied by the low pass filter 22. The frequency of the oscillation signal is divided by 7125 through the frequency divider 26 whose division ratio is 7125 (= M), the frequency divided signal is input into the other input terminal of the phase comparator 20.

A phase-locked loop (PLL) circuit is constructed by the phase comparator 20, low pass filter 22, the voltage controlled oscillator 24, and the frequency divider 26, mentioned above, and synchronizes with the reference frequency signal of 8.192 kHz. A signal having a frequency (58.368 MHz) which is 7125 times the reference frequency signal, is generated and output by the PLL circuit.

The division ratio of the frequency divider 30 is set to 1824 (= N1), and the frequency divider 30 generates and outputs a clock signal CLK1 whose frequency is the frequency of the output signal of the PLL circuit divided by 1824. Since the frequency of the output signal of the PLL circuit is 58,368 MHz, by frequency-dividing the frequency by 1824, the clock signal CLK1 of 32 kHz is generated.

Similarly, the division ratio of the frequency divider 32 is set to 1536 (= N2), and the frequency divider 32 generates and outputs a clock signal CLK2 whose frequency is the frequency of the output signal of the PLL circuit divided by 1536. Since the frequency of the output signal of the PLL circuit is 58.368 MHz, by frequency-dividing the frequency by 1536, the clock signal CLK2 of 38 kHz is generated.

Similarly, the division ratio of the frequency divider 34 is set to 1216 (= N3), and the frequency divider 34 generates and outputs a clock signal CLK3 whose frequency is the frequency of the output signal of the PLL circuit divided by 1216. Since the frequency of the output signal of the PLL circuit is 58.368 MHz, by frequency-dividing the frequency by 1216, the clock signal CLK3 of 48 kHz is generated.

In this manner, since in the clock generating circuit 300 of the present embodiment, the two kinds of clock signals CLK1 and CLK3 required for processing audio data having sampling frequencies of 32 kHz and 48 kHz, and the clock signal CLK2 of 38 kHz required for stereo modulation can be generated by using one PLL circuit, the configurations of the clock generating circuit 300 and the audio system using the same can be simplified. Moreover, since the crystal oscillator 10 of 32.768 kHz is used for generating the reference frequency of a clock, and is commercially available in a low cost, use the crystal oscillator 10 enables the cost thereof to be reduced.

Specifically, the division ratio N1 of the frequency divider 30 is set to the value determined by (32.768 × M)/(32 × N4). In the example mentioned above, since M = 7125 and N4 = 4, N1 = 1824. Setting the division ratio N1 like this, enables the clock signal CLK1 of 32 kHz to be generated by using the crystal oscillator 10 of 32.768 kHz. Otherwise, the division ratio N1 may be a value which is the value determined by (32.768 × M)/(32 × N4) further divided by the number of the power of two (2, 4, 8, ..., 2ⁿ (=2ⁿ (n is an integer being equal to or greater than 0))). In this case, a clock signal CLK1' having a frequency which is 32 kHz multiplied by the power of two is generated, thereby, frequency-division of the clock signal CLK1' enables the clock signal CLK1 of 32 kHz to be generated easily. Moreover, setting the division ratio N1 to a value which is the value determined by (32.768 × M)/(32 × N4) divided by 4, enables a clock signal having a frequency matching to the sampling frequency of 128 kHz used for such as an MP3, to be generated directly.

Similarly, the division ratio N2 of the frequency divider 32 is set to the value determined by (32.768 × M)/(32 × N4). In the example mentioned above, since M = 7125 and N4 = 4, N2 = 1536. Setting the division ratio N2 like this, enables the clock signal CLK2 of 38 kHz to be generated by using the crystal oscillator 10 of 32.768 kHz. Otherwise, the division ratio N2 may be a value which is the value determined by (32.768 × M)/(32 × N4) further divided by the number of the power of two (2, 4, 8, ..., 2ⁿ). In this case, a clock signal CLK2' having a frequency which is 38 kHz multiplied by the power of two is generated, thereby, frequency-division of the clock signal CLK2' enables the clock signal CLK2 of 38 kHz to be generated easily.

Moreover, the division ratio N3 of the frequency divider 34 is set to the value determined by (32.768 × M)/(48 × N4). In the example mentioned above, since M = 7125 and N4 = 4, N3 = 1216. Setting the division ratio N3 like this, enables the clock signal CLK3 of 48 kHz to be generated by using the crystal oscillator 10 of 32.768 kHz. Otherwise, the division ratio N3 may be a value which is the value determined by (32.768 × M)/(48 × N4) further divided by the number of the power of two (2, 4, 8, ..., 2ⁿ) . In this case, a clock signal CLK3' having a frequency which is 48 kHz multiplied by the power of two is generated, thereby, frequency-division of the clock signal CLK3' enables the clock signal CLK3 of 48 kHz to be generated easily. Moreover, setting the division ratio N3 to a value which is the value determined by (32.768 × M)/(48 × N4) divided by 2, enables a clock signal having a frequency matching to the sampling frequency of 96 kHz used for such as an MP3, to be generated directly.

Moreover, by causing the division ratio N4 of the frequency divider 14, the division ratio M of the frequency divider 26, the division ratio N1 of the frequency divider 30, the division ratio N2 of the frequency divider 32, and the division ratio N3 of the frequency divider 34, mentioned above, to be integer, respectively, the configurations of each frequency divider are simplified, enabling the configurations of the clock generating circuit 300 and the audio system using the same to be simplified further.

Moreover, the present invention is not limited to the above mentioned embodiments, instead, various modifications can be applied, within the gist of the present invention. Although in the above mentioned embodiments, an oscillation signal of the oscillator 12 is input into the phase comparator 20 through the frequency divider 14, the oscillation signal of the oscillator 12 may be directly input into the phase comparator 20 as a reference frequency signal by eliminating the frequency divider 14.

### Industrial Applicability

According to the present invention, since two kinds of clock signals required for processing audio data having sampling frequencies of 32 kHz and 48 kHz, widely used in digital audio, and a clock signal of 38 kHz required for stereo modulation, can be generated by a common clock generating circuit using one PLL circuit, the configuration of the clock generating circuit can be simplified. Moreover, the crystal oscillator of 32.768 kHz is used for generating the reference frequency of a clock, and commercially available in a low cost, use of the crystal oscillator enables the cost of the clock generating circuit to be reduced.

## Claims

1. A clock generating circuit comprising:
an oscillator for generating a reference frequency signal by using a crystal oscillator having a resonance frequency of 32.768 kHz;
a phase-locked loop circuit for synchronizing with the reference frequency signal generated by the oscillator and generating a signal having a frequency which is M times the reference frequency signal;
a first frequency divider for generating a first clock signal having a frequency which is an integer multiple of 32 kHz by frequency-dividing the signal generated by the phase-locked loop circuit at a division ratio N1;
a second frequency divider for generating a second clock signal having a frequency which is an integer multiple of 38 kHz by frequency-dividing the signal generated by the phase-locked loop circuit at a division ratio N2; and
a third frequency divider for generating a third clock signal having a frequency which is an integer multiple of 48 kHz by frequency-dividing the signal generated by the phase-locked loop circuit at a division ratio N3.

2. The clock generating circuit according to claim 1, wherein
the division ratio N1 of the first frequency divider is set to a value determined by (32.768 × M)/(32 × N4), or a value which is the division of the former value by 2ⁿ (n is an integer being equal to or greater than zero), when the reference frequency signal has a frequency which is (1/N4) times of 32.768 kHz.

3. The clock generating circuit according to claim 1, wherein
the division ratio N2 of the second frequency divider is set to a value determined by (32.768 × M)/(38 × N4), or a value which is the division of the former value by 2ⁿ (n is an integer being equal to or greater than zero), when the reference frequency signal has a frequency which is (1/N4) times of 32.768 kHz.

4. The clock generating circuit according to claim 1, wherein
the division ratio N3 of the third frequency divider is set to a value determined by (32.768 × M)/(48 × N4), or a value which is the division of the former value by 2ⁿ (n is an integer being equal to or greater than zero), when the reference frequency signal has a frequency which is (1/N4) times of 32.768 kHz.

5. The clock generating circuit according to claim 1, wherein
the N1, N2, N3, N4, and M are integers.

6. An audio system comprising:
the clock generating circuit according to claim 1;
an audio processing section for performing audio data reproduction by using at least one of the first and third clock signals generated by the clock generating circuit; and
an FM transmitter into which the audio data reproduced by the audio processing section is input, for transmitting a signal subjected to FM stereo modulation and FM modulation with respect to the input audio data by using the second clock signal generated by the clock generating circuit.

7. The audio system according to claim 6, wherein
configurations of the clock generating circuit, the audio processing section, and the FM transmitter are formed on a semiconductor substrate by means of a CMOS process or an MOS process.
